# EUROPÄISCHE PATENTSCHRIFT

(11) **EP 4 420 238 B1**
(45) Veröffentlichungstag und Bekanntmachung des Hinweises auf die Patenterteilung: **28.10.2026**
(21) Anmeldenummer: 23761915.0
(22) Anmeldetag: 28.08.2023
(51) Int. Cl.: H03M 7/30, H03M 7/40

(54) **VERFAHREN ZUR KOMPRESSION UND DEKOMPRESSION VON LOG-DATEIEN UND INFORMATIONSTECHNISCHES SYSTEM**
METHOD FOR THE COMPRESSION AND DECOMPRESSION OF LOG FILES AND INFORMATION TECHNOLOGY SYSTEM
PROCÉDÉ DE COMPRESSION ET DE DÉCOMPRESSION DE FICHIERS JOURNAUX ET SYSTÈME DE TECHNOLOGIE DE L'INFORMATION

(30) Priorität: 05.10.2022 DE 102022003682
(43) Veröffentlichungstag der Anmeldung: 28.08.2024
(73) Patentinhaber: Mercedes-Benz Group AG, 70372 Stuttgart (DE)
(72) Erfinder: Wilmer, Thorsten, 71063 Sindelfingen (DE)
(74) Vertreter: Novagraaf Group
(86) Internationale Anmeldenummer: PCT/EP2023/073483
(87) Internationale Veröffentlichungsnummer: WO 2024/074249

(56) Entgegenhaltungen:
- EP-A1- 3 435 236
- EP-A1- 3 442 125
- EP-A1- 3 490 153
- US-A1- 2013 262 487

## Beschreibung

Die Erfindung betrifft ein Verfahren zur Kompression und Dekompression von Log-Dateien unter Verwendung von anpassbaren Wörterbüchern sowie ein informationstechnisches System zur Durchführung des Verfahrens.

Informationstechnische Systeme wie PCs oder eingebettete Systeme bestehen aus Hardware- und Softwarekomponenten. In der Entwicklung solcher Systeme kann es erforderlich sein das Verhalten besagter Hardware- und Softwarekomponenten im Betrieb aufzuzeichnen und zur Überprüfung der korrekten Funktionsweise bzw. zum Auffinden von Fehlern zu analysieren. Hierzu zählt auch das sogenannte "Debugging". Das Verhalten der entsprechenden Hardware- und/oder Softwarekomponente wird in Form von sogenannten Log-Nachrichten oder Log-Dateien dokumentiert. Eine Log-Datei kann von der relevanten Hardware- oder Softwarekomponente selbst erzeugt werden oder auch durch eine die entsprechende Komponente überwachende Einheit. Das nachträgliche Analysieren der entsprechenden Log-Dateien ist mit unterschiedlichen Programmen möglich, beispielsweise eine manuelle Analyse mittels eines Editors.

Je nach Komplexität der zu überwachenden Hardware- und/oder Softwarekomponente und der durch diese Komponente bereitgestellten Funktionalität können entsprechende Log-Dateien unterschiedliche groß werden, das heißt vergleichsweise wenig oder viel Speicherplatz auf einem Speichermedium in Anspruch nehmen. Entsprechend ist bei einer eingeschränkten Datenübertragungsrate viel Zeit zum Übertragen der Log-Dateien zwischen Systemen erforderlich und es wird viel Speicherplatz auf dem jeweiligen Speichermedium beansprucht. Es ist somit wünschenswert die Größe entsprechender Log-Dateien zu reduzieren.

In der IT sind verschiedene Kompressions-und Dekompressionsalgorithmen bzw. Verfahren bekannt. zlib ist beispielsweise eine freie Programmbibliothek zum Komprimieren und Dekomprimieren von Daten mit dem Deflate-Algorithmus. Es handelt sich hierbei im Gegensatz zur verlustbehafteten Kompression um verlustfreie Kompression. Der Deflate-Algorithmus zählt zu den sogenannten Wörterbuchmethoden, bei denen die Inhalte von Log-Dateien, also in der Regel Zeichenfolgen wie Strings, unter Berücksichtigung des Inhalts eines jeweiligen Wörterbuchs in kürzere Zeichenketten gewandelt werden. In einem solchen Wörterbuch sind Einträge für die typischerweise und insbesondere besonders häufig in einer Log-Datei vorkommenden Zeichenfolgen enthalten, welche definieren durch welche Zeichenketten diese Zeichenfolgen jeweils ersetzt werden. Eine Zeichenfolge wie "ABCDE" kann dann beispielsweise durch die Zeichenkette "a" ersetzt werden. Hierdurch wird der Inhalt der Log-Datei reduziert und entsprechend der erforderliche Speicherbedarf gesenkt.

Ein weiterer Datenkompressions-Algorithmus ist "Brotli", welcher auf einem vordefinierten 120 KiB großen Wörterbuch basiert. Nachteilig ist dabei jedoch, dass aufgrund des fest vorgegebenen Wörterbuchs lediglich bestimmte, vordefinierte Zeichenfolgen in ihrer Länge reduziert werden können.

Im Gegensatz zu Wörterbüchern mit einer fest vorgegebenen Größe und vorgegebenen Inhalten sind auch anpassbare Wörterbücher bekannt. Ein darauf aufbauendes Datenkompressionsverfahren ist beispielsweise aus der DE 43 40 591 C2 bekannt. Das Dokument beschreibt Datenkompressions-Initialisierungs-Verfahren, die auf verschiedene Arten von Eingabedaten und verschiedene Datenstrukturen anpassbar sind, um das Datenkompressionsverhältnis zu erhöhen und den Speicherplatz, der in einem Kompressions-/Dekompressions-System, das auf einem Wörterbuch basiert, erforderlich ist, zu reduzieren. Dabei werden die Einträge in entsprechenden Wörterbüchern in Abhängigkeit der zu komprimierenden Eingangsdaten erzeugt, der Inhalt des Wörterbuchs also ergänzt, sodass auch ursprünglich dem Wörterbuch unbekannte Eingangsdaten komprimierbar sind. Die entsprechenden Inhalte können dabei auch mehrfach kodiert werden.

Ferner offenbart die US 2015/0066881 A1 ein Verfahren zur Kompression von Logdateien, welches das effektive Sammeln von Daten von Netzwerkknoten erlaubt. Dabei wird ein tabellenbasierter Kompressionsalgorithmus zum Komprimieren der Logdateien eingesetzt. Die zugrunde liegende Tabelle wird mittels spezieller Trainingsdaten erzeugt. Dies ermöglicht das Aufbauen einer umfangreichen Übersetzungsdatenbank.

Zudem offenbart die US 2021/0407220 A1 ein System, ein Verfahren und eine Vorrichtung zur Verwaltung des Sammelns von Daten in einem Fahrzeug. Die Druckschrift beschreibt das Erzeugen einer Logdatei auf der Recheneinheit eines Fahrzeugs und die Verarbeitung der Logdatei im Fahrzeug oder auf einer zum Fahrzeug externen Recheneinheit.

Ferner offenbart die EP 3 435 236 A1 ein Verfahren zum Sammeln von Logs mittels einer Log-Erzeugungsvorrichtung und einer Log-Sammelvorrichtung. Dabei erzeugt die Log-Erzeugungsvorrichtung ein Log und übermittelt dieses unkomprimiert an die Log-Sammelvorrichtung. Die Log-Sammelvorrichtung untersucht das Log und erzeugt ein auf den Inhalt des Logs maßgeschneidertes versioniertes Wörterbuch. Dieses maßgeschneiderte versionierte Wörterbuch überträgt die Log-Sammeleinrichtung zur Anwendung an die Log-Erzeugungsvorrichtung zurück, woraufhin die Log-Erzeugungsvorrichtung das versionierte Wörterbuch auf das Log zur Erzeugung eines komprimierten Logs anwendet. Anschließend überträgt die Log-Erzeugungsvorrichtung das komprimierte Log an die Log-Sammelvorrichtung. Die Log-Sammelvorrichtung wendet das versionierte Wörterbuch zum Ableiten eines unkomprimierten Logs auf das komprimierte Log an.

Ferner offenbart die EP 3 490 153 A1 ein Verfahren zur Datenkompression und - dekompression. Das Verfahren wird zum Komprimieren und Dekomprimieren von Daten mit einer festgelegten Länge eingesetzt. Als Daten dienen dabei die Messdaten von Sensoren mit einer festgelegten Datenstruktur.

Ferner offenbart die EP 3 442 125 A1 eine Sensornetzwerkanordnung zur Reduktion der in einem Fahrzeug verarbeiteten Daten. Mit Hilfe der Sensornetzwerkanordnung lässt sich die über ein fahrzeuginternes Kommunikationsnetz zu übertragende Datenmenge reduzieren. Hierzu wird ein von einem Sensor erzeugter Datenstrom komprimiert bevor er über das Kommunikationsnetz übertragen wird.

Zudem offenbart die US 2013/262487 A1 ein Verfahren und ein System zur Verwaltung von Logs, welches sich durch eine Beschleunigung der zur Erzeugung von Logs erforderlichen Zeitdauer auszeichnet. Dabei erfolgt eine Steuerung einer Ausgabeeinheit zur Ausgabe des Logs unter Berücksichtigung von Nachrichtenformatinformationen.

Der vorliegenden Erfindung liegt die Aufgabe zugrunde ein verbessertes Verfahren zur Kompression und Dekompression von Log-Dateien anzugeben, mit dessen Hilfe der Aufwand in der Verarbeitung von Log-Dateien reduziert wird und dabei dennoch eine vergleichsweise große Speicherbedarfsreduktion bzw. Dateigrößenreduktion bei unterschiedlichen Ausgangsdateien möglich ist.

Bei einem Verfahren zur Kompression und Dekompression von Log-Dateien unter Verwendung von anpassbaren Wörterbüchern werden die folgenden Verfahrensschritte ausgeführt:
- Überwachen einer Laufzeitkomponente und Erzeugen einer Ursprungslogdatei durch eine Überwachungseinheit, wobei die Ursprungslogdatei das während der Überwachung beschriebene Verhalten der Laufzeitkomponente dokumentiert;
- Einlesen der Ursprungslogdatei in einen Log-Kodierer durch die Überwachungseinheit;;
- Erzeugen einer kodierten Log-Datei durch Anwenden einer Kodierungstabelle auf die Ursprungslogdatei durch den Log-Kodierer;
- Übertragen der kodierten Log-Datei von der Überwachungseinheit an eine Entwicklereinheit;
- Einlesen der kodierten Log-Datei in einen Log-Dekodierer durch die Entwicklereinheit und Beziehen eines Versionshinweises auf ein durch den Log-Kodierer verwendete versionierte Wörterbuch oder auf die Kodierungstabelle von der Überwachungseinheit;
- Zugriff auf eine Wörterbuchdatenbank, umfassend unterschiedlich versionierte Wörterbücher, durch die Entwicklereinheit, Bereitstellen das dem Versionshinweis entsprechenden Wörterbuchs dem Log-Dekodierer und initialisieren einer Kodierungstabelle aus dem versionierten Wörterbuch durch den Log-Dekodierer; und
- Erzeugen einer dekodierten Log-Datei durch Anwenden der Kodierungstabelle auf die kodierte Log-Datei durch den Log-Dekodierer.

Erfindungsgemäß ist es dabei vorgesehen, dass
- die Überwachungseinheit die Ursprungslogdatei einliest, die Kodierungstabelle in Abhängigkeit der von der Ursprungslogdatei enthaltenen Informationen erzeugt, ein Wörterbuch aus der Kodierungstabelle ableitet und mit einem Versionshinweis versieht und das so versionierte Wörterbuch an die Wörterbuchdatenbank zum Speichern überträgt; und
- die Überwachungseinheit die zum Erzeugen der kodierten Log-Datei verwendete Kodierungstabelle aus der Ursprungslogdatei oder aus einem aus der Wörterbuchdatenbank ausgelesenen versionierten Wörterbuch durch den Log-Kodierer initialisiert.

Mit Hilfe des erfindungsgemäßen Verfahrens lässt sich eine besonders umfassende Datenreduktion erreichen, da anpassbare Wörterbücher verwendet werden. So können Einträge in den jeweiligen Wörterbüchern ergänzt werden, um auch bisher unbekannte Einträge von Ursprungslogdateien komprimieren zu können. Der Verarbeitungsaufwand ist dabei dank der Versionierung der Wörterbücher besonders gering. So werden in Abhängigkeit des Inhalts einer jeweiligen Ursprungslogdatei, welcher wiederum von der überwachten und/oder überwachenden Hardware- und Softwarekonfiguration sowie der von der Laufzeitumgebung bereitgestellten Funktionalität abhängt, verschiedene Versionen an Wörterbüchern bzw. diesen zu Grunde liegenden Kodierungstabellen erschaffen, welche somit auf die jeweilige Ursprungslogdatei "maßgeschneidert" sind. Zum Komprimieren der Ursprungslogdateien bzw. Dekomprimieren der komprimierten Ursprungslogdateien ist es dann lediglich erforderlich aus dem jeweilig relevanten Wörterbuch eine Kodierungstabelle abzuleiten und diese zum "Übersetzen" auf die jeweilige Log-Datei anzuwenden. Mit Hilfe des Versionshinweises ist eine eindeutige, zuverlässige und schnelle Referenzierung zwischen einer jeweiligen Log-Datei und dem auf diese Log-Datei anzuwenden Wörterbuch, bzw. die Kodierungstabelle (zum Komprimieren einer Ursprungslogdatei oder zum Dekomprimieren einer kodierten Log-Datei) möglich. Ein versioniertes Wörterbuch und die diesem zu Grunde liegende Kodierungstabelle weisen dabei dieselbe Version auf.

Die Laufzeitkomponente wird von einer Hardwarekomponente und/oder einer Softwarekomponente ausgebildet sein. Die Laufzeitkomponente kann intern oder extern zur Überwachungseinheit ausgeführt sein und wird von der Überwachungseinheit überwacht. Bei der Lautzeitkomponente kann es sich beispielsweise um ein auf einem PC laufendes Programm oder ein eingebettetes System (oder eine Hardware-/SoftwareKomponente davon) in einem Fahrzeug handeln. Die Überwachungseinheit erzeugt die Ursprungslogdatei oder empfängt diese von der Laufzeitkomponente. Der Log-Kodierer ist Bestandteil der Überwachungseinheit und liest die Ursprungslogdatei ein.

Der Log-Kodierer bzw. die Überwachungseinheit wählt dann dasjenige versionierte Wörterbuch bzw. Kodierungstabelle aus, welche(s) zum Kodieren der eingelesenen Ursprungslogdatei vorgesehen ist. Diese Entscheidung wird auf Basis verschiedener Randbedingungen getroffen, worauf im Späteren noch detailliert eingegangen wird.

Bei dem Wörterbuch handelt es sich um eine Binärdatei, auch als Binary-File oder kurz "Binary" bezeichnet. Aus dem entsprechend versionierten Wörterbuch initialisiert der Log-Kodierer eine jeweilige Kodierungstabelle und wendet diese auf die Ursprungslogdatei an, um die kodierte Log-Datei zu erzeugen. In einem jeweiligen versionierten Wörterbuch ist somit eine Zuordnung gespeichert, welche Zeichenfolge der Ursprungslogdatei durch welche Zeichenkette ersetzt werden soll. Bei der Zeichenkette handelt es sich ebenfalls um eine Zeichenfolge, welche jedoch kürzer ist als die ursprüngliche Zeichenfolge. Die Begriffe "Zeichenfolge" und "Zeichenkette" wurden hier also zum besseren Verständnis gewählt. Je nach Inhalt der Ursprungslogdatei enthält diese ganz unterschiedliche Zeichenfolgen. Diesem Sachverhalt wird durch die unterschiedlichen Versionen der Wörterbücher Rechnung getragen, sodass in einem jeweiligen versionierten Wörterbuch nur solche Zuordnungen zwischen Zeichenfolgen und Zeichenketten enthalten sind, welche auch hauptsächlich in einer jeweiligen Ursprungslogdatei vorkommen. So lässt sich verhindern, dass ein Wörterbuch (bzw. die daraus initialisierte/diesem zu Grunde liegende Kodierungstabelle) auf eine Ursprungslogdatei angewendet wird, welches Zuordnungen enthält für Zeichenfolgen, die in der Ursprungslogdatei nur besonders wenig oder gar nicht vorkommen. So kann der Speicherbedarf der Wörterbücher ebenfalls reduziert werden.

Durch das Übersetzen des Inhalts einer jeweiligen Ursprungslogdatei mittels der (aus dem Wörterbuch abgeleiteten) Kodierungstabelle, also durch das eigentliche Komprimieren, sinkt der Speicherplatzbedarf der kodierten Log-Datei gegenüber der Ursprungslogdatei. Somit ist bei gleicher Übertragungsbandbreite ein schnelleres Übertragen der kodierten Log-Datei von der Überwachungseinheit an die Entwicklereinheit möglich als beim Übertragen der (unkomprimierten) Ursprungslogdatei. Zudem wird hierdurch die Cybersicherheit erhöht, da ein Angreifer die so übermittelte kodierte Log-Datei nur dann lesen kann, wenn der Angreifer Zugriff auf das verwendete Wörterbuch bzw. die daraus initialisierte Kodierungstabelle hat.

Eine Wörterbuchdatenbank kann dabei von der Überwachungseinheit, der Entwicklereinheit und/oder auch extern hierzu vorhanden sein. Insbesondere wenn die Wörterbuchdatenbank extern zur Überwachungseinheit und Entwicklereinheit ausgeführt ist und die Überwachungseinheit und Entwicklereinheit beide Lese- bzw. Lese- und Schreibzugriff auf die Wörterbuchdatenbank haben, ist eine besonders effiziente Datenübertragung zwischen Überwachungseinheit und Entwicklereinheit möglich, da dann lediglich die kodierte Log-Datei von der Überwachungseinheit an die Entwicklereinheit übermittelt werden muss und die Entwicklereinheit das entsprechend versionierte Wörterbuch aus der Wörterbuchdatenbank über einen separaten Kommunikationskanal empfängt. Hierbei handelt es sich bevorzugt um einen Kommunikationskanal mit einer im Vergleich hohen Datenübertragungsrate.

Der Log-Dekodierer verfügt über die Information, welches versionierte Wörterbuch er verwenden muss, um die entsprechende Kodierungstabelle initialisieren zu können, welche zum Dekodieren der kodierten Log-Datei benötigt wird. Der Versionshinweis kann auf unterschiedlichen Wegen übertragen werden, worauf ebenfalls im Späteren noch eingegangen wird.

Die dekodierte Log-Datei entspricht im Wesentlichen oder gänzlich der Ursprungslogdatei. Dies ermöglicht eine Verarbeitung der Ursprungslogdatei auf der Entwicklereinheit, um beispielsweise die korrekte Funktionsweise der Laufzeitkomponente beurteilen zu können bzw. Bugs aufzufinden.

Es ist vorgesehen, dass die Überwachungseinheit die Ursprungslogdatei einliest, eine Kodierungstabelle in Abhängigkeit der von der Ursprungslogdatei enthaltenen Informationen erzeugt, ein Wörterbuch aus der Kodierungstabelle ableitet und mit einem Versionshinweis versieht und das so versionierte Wörterbuch an die Wörterbuchdatenbank zum Speichern überträgt. Mittels dieses Ablaufs lassen sich an eine jeweilige Ursprungslogdatei angepasste Wörterbücher erzeugen.

Ein entsprechend versioniertes Wörterbuch eignet sich somit zum Kodieren bzw. Dekodieren einer in Abhängigkeit der hardware- und/oder softwareseitigen Ausgestaltung der Laufzeitkomponente erzeugten Ursprungslogdatei. So wird nämlich je nach Hardware- und/oder Softwareausführung der Laufzeitkomponente bzw. der von der Laufzeitkomponente ausgeführten Funktionalität der Inhalt der Ursprungslogdatei anders aussehen. Oftmals ist es so, dass auf der gleichen Hardware unter der gleichen Softwareversion dieselbe Anwendung unter verschiedenen äußeren Randbedingungen durchgeführt wird. Für diesen Fall kann dann das gleiche Wörterbuch verwendet werden. Wird dann eine neue Software aufgespielt und/oder eine andere Funktionalität ausgeführt, so kann ein abweichend versioniertes Wörterbuch verwendet werden, da sich der wesentliche Inhalt der Ursprungslogdatei entsprechend ändert. Analog können anders versionierte Wörterbücher verwendet werden, wenn sich die Hardware der Laufzeitkomponente ändert.

Die Überwachungseinheit prüft dabei, welche Version, sprich welcher Versionshinweis, dem jeweiligen Wörterbuch bei der Erzeugung zuzuordnen ist. So kann die Kodierungstabelle bzw. das darauf aufbauende Wörterbuch inhaltlich mit dem in der Wörterbuchdatenbank bereits bevorrateten Wörterbüchern verglichen werden. Wird derselbe Inhalt festgestellt, so handelt es sich um ein und dieselbe Version. Kann jedoch keine Übereinstimmung festgestellt werden, so handelt es sich um eine neue Version. Die Zuteilung von Versionshinweisen kann dann nach einem vordefinierten Muster erfolgen, beispielsweise eine fortlaufende Nummerierung.

Das Einlesen der Ursprungslogdatei, Erzeugen der Kodierungstabelle und Ableiten des Wörterbuchs aus der Kodierungstabelle erfolgt durch die Überwachungseinheit insbesondere nach dem Einlesen der Ursprungslogdatei in den Log-Kodierer und vor dem etwaigen Einlesen des versionierten Wörterbuchs und Initialisieren der Kodierungstabelle durch den Log-Kodierer. So können nämlich in den Log-Kodierer einlesbare und dort initialisierbare versionierte Wörterbücher durch die Überwachungseinheit vor einer Kodierung der Ursprungslogdatei selbst erzeugt werden. Dies ermöglicht eine Kodierung von Ursprungslogdateien mit bisher unbekanntem Inhalt, sollten für eine solche Ursprungslogdatei noch keine versionierten Wörterbücher in der Wörterbuchdatenbank vorhanden sein. Nachdem aus der Ursprungslogdatei eine entsprechende Kodierungstabelle und ein entsprechend versioniertes Wörterbuch erzeugt wurde, kann dann die Kodierungstabelle direkt zum Kodieren verwendet werden und das erzeugte versionierte Wörterbuch an die Wörterbuchdatenbank zum Abspeichern übermittelt werden.

Werden hingegen Ursprungslogdateien mit einem gewohnten Muster, sprich Inhalt, verarbeitet, so ist es nicht zwangsweise erforderlich, dass jedes Mal der Inhalt der Ursprungslogdatei zuerst ausgelesen und überprüft wird und ggf. entsprechend eine neue Kodierungstabelle und daraus ein neues versioniertes Wörterbuch erzeugt und abgelegt wird. So kann stattdessen ein für die jeweilige Ursprungslogdatei passendes versioniertes Wörterbuch aus der Wörterbuchdatenbank ausgelesen werden. Beispielsweise lässt sich auch aus einer Konfiguration der überwachten Laufzeitkomponente und/oder der von der Laufzeitkomponente bereitgestellten Funktionalität ermitteln, welches versionierte Wörterbuch zu verwenden ist. Ein konkretes Beispiel wäre ein bestimmtes Fahrzeugsteuergerät mit einer bestimmten Firmware, welches eine bestimmte Aufgabe erledigt, bspw. ein Motorsteuergerät, welches im Regelbetrieb eine Kraftstoffeinspritzung steuert. Für diesen Anwendungsfall werden die jeweiligen Ursprungslogdateien einen bestimmten festen Aufbau aufweisen, welcher sich dann einem jeweiligen versionierten Wörterbuch zuordnen lässt.

Hierzu kann eine entsprechende Wörterbuchdatenbank auch ergänzend in der Überwachungseinheit vorgehalten werden.

Versionierte Wörterbücher können jeweils als vollständige Datei in der Wörterbuchdatenbank gespeichert werden oder auch nach Art eines differenziellen Updates. So kann eine ursprüngliche Version des Wörterbuches in ihrer Gänze in der Wörterbuchdatenbank abgespeichert werden und darauf aufbauende Versionen lediglich den zu diesem initialen Wörterbuch ergänzenden und/oder geänderten Inhalt enthalten. Dies ermöglicht es den Speicherbedarf zum Speichern mehrerer unterschiedlicher versionierter Wörterbücher gering zu halten.

Entsprechend einer vorteilhaften Ausgestaltung des Verfahrens wird die Wörterbuchdatenbank auf einer zentralen Recheneinrichtung vorgehalten. Dies ermöglicht eine besonders effiziente und zuverlässige Verarbeitung der Log-Dateien. Bei der zentralen Recheneinrichtung kann es sich beispielsweise um einen Cloudserver handeln. Auf den Cloudserver können die unterschiedlichsten Rechensysteme Zugriff haben. Beispielsweise kann es eine Vielzahl von Überwachungseinheiten geben, welche gemeinsam die auf der zentralen Recheneinrichtung vorgehaltene Wörterbuchdatenbank aktuell halten. Analog kann es mehrere Entwicklereinheiten geben, die auf die Wörterbuchdatenbank auf der zentralen Recheneinrichtung zugreifen, um das jeweilige aktuell benötigte Wörterbuch zu laden.

Bei der Entwicklereinheit kann es sich beispielsweise um einen PC mit Netzwerk- oder Internetanbindung an die zentrale Recheneinrichtung handeln. Diese Kommunikationsverbindung ist bevorzugt kabelgebunden. Bei der Überwachungseinheit kann es sich um ein mobiles System handeln, welches direkt oder mittelbar über ein Kommunikationsmodul mit der zentralen Recheneinrichtung in Kommunikationsverbindung steht. Das Kommunikationsmodul kann beispielsweise per Mobilfunk an die zentrale Recheneinrichtung angebunden sein.

Eine weitere vorteilhafte Ausgestaltung des Verfahrens sieht ferner vor, dass der Log-Kodierer beim Erzeugen der kodierten Log-Datei in Abhängigkeit des verwendeten Wörterbuchs den Versionshinweis in die kodierte Log-Datei schreibt. Dies ermöglicht ein besonders einfaches und zuverlässiges Vermitteln des Versionshinweises von der Entwicklereinheit.

Der Versionshinweis wird insbesondere in unkodierter Art und Weise in die kodierte Log-Datei geschrieben, sodass der Log-Dekodierer bzw. die Entwicklereinheit ohne eine vorige Dekodierung den Versionshinweis auch auslesen kann und entsprechend das jeweilige zu verwendende Wörterbuch laden kann.

Entsprechend einer weiteren vorteilhaften Ausgestaltung des erfindungsgemäßen Verfahrens fragt die Entwicklereinheit den Versionshinweis proaktiv von der Überwachungseinheit ab oder liest diesen aus der kodierten Log-Datei aus.

Durch das proaktive Abfragen des Versionshinweises lässt sich die Cybersicherheit verbessern. So ist es erforderlich, dass eine Recheneinheit, die besagte Log-Datei dekodieren möchte, nicht nur die kodierte Log-Datei empfängt, Zugriff auf die entsprechende Wörterbuchdatenbank hat, sondern auch eine Information benötigt, welches Wörterbuch zum Dekodieren der kodierten Log-Datei verwendet werden muss. So muss ein entsprechender Angreifer der Überwachungseinheit eine Autorisierung vortäuschen. Dies ist eine zusätzliche Hürde.

Der Versionshinweis kann jedoch auch in die kodierte Log-Datei geschrieben werden, wodurch eine weitere Datenübertragung zwischen Überwachungseinheit und Entwicklereinheit obsolet wird. Dies ermöglicht eine noch effizientere Bandbreitenutzung im Übertragungsstrom zwischen Überwachungseinheit und Entwicklereinheit. Der Versionshinweis kann dabei generell auch verschlüsselt an die jeweilige kodierte Log-Datei angehängt sein. So wird ein passender Schlüssel zum Entschlüsseln des Versionshinweises auf der Entwicklereinheit vorgehalten.

Bevorzugt verwendet der Log-Kodierer die initialisierte Kodierungstabelle zum Erzeugen unterschiedlicher kodierter Log-Dateien aus unterschiedlichen Ursprungslogdateien weiter oder initialisiert beim Einlesen einer neuen Ursprungslogdatei die Kodierungstabelle neu.

Wie bereits ausgeführt wird die Version des Wörterbuchs bzw. der Kodierungstabelle in Abhängigkeit des Aufbaus einer jeweiligen Ursprungslogdatei gewählt. Sollen hintereinander mehrmals Ursprungslogdateien mit ähnlichem oder gleichem Inhalt verarbeitet werden, so kann der Log-Kodierer auch die für diesen Typ von Ursprungslogdatei bereits initialisierte Kodierungstabelle weiterverwenden. Ändert sich jedoch der Inhalt bzw. Typ der Ursprungslogdatei, so muss auch eine neue Kodierungstabelle initialisiert werden bzw. ein entsprechend neu versioniertes Wörterbuch erzeugt werden.

Je nach Ausführung und insbesondere Lebenszyklusphase der Überwachungseinheit bzw. der Laufzeitkomponente kann es vorkommen, dass nur Ursprungslogdateien eines bekannten Inhalts und Typs verarbeitet werden müssen. In diesem Falle ist ein ganz besonders effizienter Ablauf möglich, bei dem die Überwachungseinheit keine Wörterbücher mehr aus der Wörterbuchdatenbank auslesen muss, sondern eine zu einem Anfangszeitpunkt initialisierte Kodierungstabelle fortwährend weiterverwendet. Mit anderen Worten muss dann nicht mehr dynamisch zur Laufzeit der Überwachungseinheit eine jeweilige Kodierungstabelle erzeugt werden, sondern das Initialisieren von Wörterbüchern auf der Überwachungseinheit kann gänzlich entfallen, da direkt eine vorinitialisierte Kodierungstabelle verwendet wird. Hierdurch kann Rechenzeit von einem Prozessor der Überwachungseinheit für andere Funktionen bereitgestellt werden.

Bei einem informationstechnischen System mit einer Überwachungseinheit und einer Entwicklereinheit sind erfindungsgemäß die Überarbeitungseinheit und die Entwicklereinheit zur Durchführung eines im vorigen beschriebenen Verfahrens eingerichtet.

Bevorzugt sind die Überwachungseinheit und die Entwicklereinheit in eine gemeinsame Anlage integriert, insbesondere in ein Fahrzeug. Mit Hilfe des erfindungsgemäßen Verfahrens können so Log-Dateien im Automotive-Umfeld besonders effizient verarbeitet werden. Bei der Überwachungseinheit handelt es sich somit um ein Steuergerät eines Fahrzeuguntersystems, eine zentrale Fahrzeugrecheneinheit oder dergleichen. Entsprechend wird auch die Laufzeitkomponente durch ein Hardware- oder Softwaremodul des Fahrzeugs ausgebildet. Auch die Entwicklereinheit kann dabei Bestandteil des Fahrzeugs sein. Generell können Überwachungseinheit und Entwicklereinheit auch auf einer gemeinsamen Recheneinheit bereitgestellt sein. Die Überwachungseinheit und die Entwicklereinheit können jedoch auch durch zwei separate Recheneinheiten wie zwei separate Fahrzeugsteuergeräte ausgebildet sein. Als Fahrzeug kommen alle gängigen Straßenfahrzeuge wie PKWs, LKWs, Busse, Bagger, Traktoren und dergleichen, Schienenfahrzeuge, Wasserfahrzeuge oder Luftfahrzeuge in Frage.

Entsprechend einer weiteren vorteilhaften Ausgestaltung des informationstechnischen Systems sind die Überwachungseinheit und die Entwicklereinheit in separate Anlagen integriert oder bilden diese aus, insbesondere ist die Überwachungseinheit in ein Fahrzeug integriert und die Entwicklereinheit fahrzeugextern ausgeführt. So kann beispielsweise die Entwicklereinheit von einem mobilen Endgerät wie einem Laptop oder einem Tabletcomputer ausgestaltet sein, welches in Kommunikationsverbindung mit dem Fahrzeug geschaltet wird. Beispielsweise kann das mobile Endgerät kabelgebunden, beispielsweise über USB-Kabel oder Ethernetkabel, an eine Recheneinheit des Fahrzeugs angeschlossen sein. Auch kann eine drahtlose Datenübertragung erfolgen, beispielsweise eine WiFi basierte, Bluetooth basierte oder NFC basierte drahtlose Datenübertragung. Die Entwicklereinheit kann auch geografisch extern zum Fahrzeug ausgeführt sein und beispielsweise von einem Desktopcomputer in einem Büro ausgebildet sein. Ein entsprechendes Steuergerät des Fahrzeugs kann Informationen über ein Telekommunikationsmodul per Mobilfunk versenden und somit, insbesondere über das Internet, an die Entwicklereinheit übertragen. Eine entsprechende Datenübertragung ist zwischen Überwachungseinheit und zentraler Recheneinrichtung bzw. Entwicklereinheit und zentraler Recheneinrichtung möglich.

Weitere vorteilhafte Ausgestaltungen des erfindungsgemäßen Verfahrens zur Kompression und Dekompression von Log-Dateien unter Verwendung von anpassbaren Wörterbüchern ergeben sich auch aus dem Ausführungsbeispiel, welches nachfolgend unter Bezugnahme auf die Figur näher beschrieben wird.

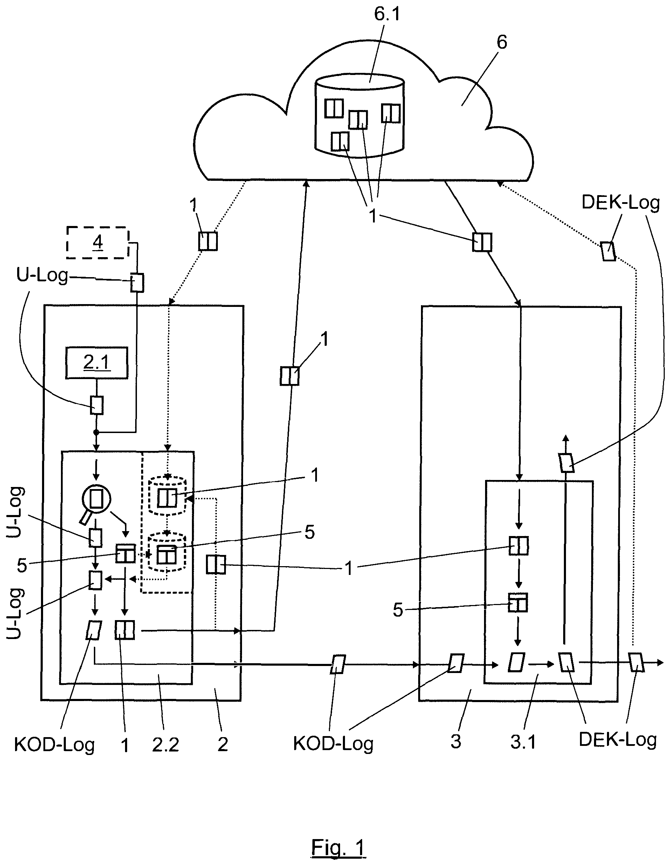

Dabei zeigt Figur 1 eine schematisierte Darstellung der an einem erfindungsgemäßen Verfahren zur Kompression und Dekompression von Log-Dateien beteiligten Komponenten.

Figur 1 verdeutlicht den Ablauf eines erfindungsgemäßen Verfahrens zur Kompression und Dekompression von Log-Dateien unter Verwenden von anpassbaren Wörterbüchern 1. Dabei überwacht eine Überwachungseinheit 2 das Verhalten einer Laufzeitkomponente 2.1 und/oder 4. Die Laufzeitkomponente 2.1 kann in die Überwachungseinheit 2 integriert sein oder auch wie die Laufzeitkomponente 4 extern hierzu ausgeführt sein. Das Verhalten der Laufzeitkomponente 2.1, 4 wird mittels einer Ursprungslogdatei U-Log dokumentiert. Die Ursprungslogdatei U-Log kann von der Laufzeitkomponente 2.1, 4 oder auch von der Überwachungseinheit 2 erzeugt werden.

Die Ursprungslogdatei U-Log wird durch die Überwachungseinheit 2 mittels eines Log-Kodierers 2.2 verarbeitet. Die Überwachungseinheit 2 überprüft, wie durch eine Lupe angedeutet, den Inhalt der Ursprungslogdatei U-Log und leitet hieraus eine Kodierungstabelle 5 ab. Die Kodierungstabelle 5 beschreibt dabei, nach welchen Regeln welche Inhalte, bspw. Zeichenfolgen, der Ursprungslogdatei U-Log komprimiert werden sollen, also in welche Zeichenketten gewandelt werden sollen. Das Erzeugen der Kodierungstabelle 5 ist flexibel in Abhängigkeit des Inhalts der Ursprungslogdatei U-Log möglich, sodass anpassbare Wörterbücher 1 erzeugbar sind.

Werden also bisher unbekannte Inhalte, sprich eine bestimmte Zeichenfolge zum ersten Mal, in der Ursprungslogdatei U-Log angetroffen, so werden eigens neue Kompressionsvorschriften geschaffen, wie diese komprimiert, also in eine kürzere Zeichenkette übersetzt, werden sollen. Die so erzeugte Kodierungstabelle 5 wird dann von der Überwachungseinheit 2 mit einem Versionshinweis versehen und in Form eines versionierten Wörterbuchs 1 an eine Wörterbuchdatenbank 6.1 zum Speichern übertragen. In dem in Figur 1 gezeigten Ausführungsbeispiel ist die Wörterbuchdatenbank 6.1 extern zur Überwachungseinheit 2 ausgeführt. Dabei ist die Wörterbuchdatenbank 6.1 in eine zentrale Recheneinrichtung 6, beispielsweise einen Cloudserver, integriert. Die so erzeugte Kodierungstabelle 5 und/oder das so erzeugte versionierte Wörterbuch 1 könnten, wie durch gestrichelte Linien symbolisiert, auch zur weiteren Anwendung in der Überwachungseinheit 2 vorgehalten werden.

Auf die (bereits inhaltlich überprüfte) Ursprungslogdatei U-Log wird entweder die in Abhängigkeit des Inhalts frisch initialisierte Kodierungstabelle 5 oder eine aus einem bereits erzeugten versionierten Wörterbuch 1 initialisierte Kodierungstabelle 5 (siehe der gestrichelte Pfad) angewendet. Der Log-Kodierer 2.2 erzeugt somit hieraus eine kodierte Log-Datei KOD-Log.

Die kodierte Log-Datei KOD-Log weist einen geringeren Speicherbedarf auf als die Ursprungslogdatei U-Log, da sie eine geringere Anzahl an Zeichenketten enthält. Die kodierte Log-Datei KOD-Log wird dann an eine Entwicklereinheit 3 übertragen. Aufgrund der reduzierten Speichergröße ist hier auch bei einer geringer zur Verfügung stehenden Datenübertragungsrate ein vergleichsweise schneller Versand möglich. Nun gilt es die kodierte Log-Datei KOD-Log auf der Entwicklereinheit 3 zu dekodieren, um diese weiter zu bearbeiten.

Die Entwicklereinheit 3 benötigt hierzu zuerst eine Information, mit welchem versionierten Wörterbuch 1 das Dekodieren möglich ist. Diese den entsprechenden Versionshinweis betreffende Information kann die Entwicklereinheit 3 von der Überwachungseinheit 2 proaktiv abfragen oder gegebenenfalls auch aus der kodierten Log-Datei KOD-Log auslesen, sollte diese Information an diese angehängt worden sein. Die Entwicklereinheit 3 greift dann auf die Wörterbuchdatenbank 6.1 der zentralen Recheneinrichtung 6 zu und liest das entsprechend geeignete versionierte Wörterbuch 1 aus.

Das passend versionierte Wörterbuch 1 sowie die kodierte Log-Datei KOD-Log werden in einen Log-Dekodierer 3.1 eingelesen. Der Log-Dekodierer 3.1 initialisiert eine entsprechende Kodierungstabelle 5 aus dem respektiven versionierten Wörterbuch 1 und wendet die Kodierungstabelle 5 dann auf die kodierte Log-Datei KOD-Log an, um daraus eine dekodierte Log-Datei DEK-Log zu erzeugen. Die entsprechend dekodierte Log-Datei DEK-Log kann dann zur Auswertung des Systemverhaltens der Laufzeitkomponente 2.1 bzw. 4 ausgewertet werden. Hierzu kann die dekodierte Log-Datei DEK-Log auf der Entwicklereinheit 3 selbst verarbeitet werden und/oder an Extern, beispielsweise zur zentralen Recheneinrichtung 6, übermittelt werden.

Mit Hilfe des erfindungsgemäßen Verfahrens ist eine besonders effiziente Verarbeitung von Log-Dateien möglich, da auch besonders umfassende Ursprungslogdateien U-Log speicherplatzeffizient komprimiert werden können und dabei der zum Komprimieren und Dekomprimieren erforderliche Aufwand gering ausfällt. So gibt es eine begrenzte Anzahl möglicher Ausführungsformen von Ursprungslogdateien U-Log für die jeweils ein passendes versionierte Wörterbuch 1 vorgehalten wird. Werden entsprechende Hardware- und/oder Softwarekomponenten weiterentwickelt, so werden entsprechende neue Versionen der Wörterbücher 1 erzeugt und für die spätere Anwendung in der Wörterbuchdatenbank 6.1 vorgehalten. Die Entwicklereinheit 3 muss dann ein entsprechendes Wörterbuch 1 nicht neu aufbauen, sondern muss lediglich den Versionshinweis von der Überwachungseinheit 2 beziehen, um das jeweils passende Wörterbuch 1 aus der Wörterbuchdatenbank 6.1 auszulesen. Das jeweilige Wörterbuch 1 muss dann nicht von der Überwachungseinheit 2 an die Entwicklereinheit 3 übertragen werden, wodurch zusätzlich von der Überwachungseinheit 2 an die Entwicklereinheit 3 übertragene Datenmenge reduziert wird. Insbesondere wenn die Überwachungseinheit 2 in ein Fahrzeug integriert ist und kodierte Log-Dateien KOD-Log per mobiler Datenanbindung versendet werden, lässt sich so eine geringe zur Verfügung stehende Übertragungsbandbreite effizient nutzen.

## Patentansprüche

1. Verfahren zur Kompression und Dekompression von Log-Dateien unter Verwendung von anpassbaren Wörterbüchern (1),
wobei die folgenden Verfahrensschritte ausgeführt werden:
- Überwachen einer Laufzeitkomponente (2.1, 4) und Erzeugen einer Ursprungslogdatei (U-Log) durch eine Überwachungseinheit (2), wobei die Ursprungslogdatei (U-Log) das während der Überwachung beschriebene Verhalten der Laufzeitkomponente (2.1, 4) dokumentiert;
- Einlesen der Ursprungslogdatei (U-Log) in einen Log-Kodierer (2.2) durch die Überwachungseinheit (2);
- Erzeugen einer kodierten Log-Datei (KOD-Log) durch Anwenden einer Kodierungstabelle (5) auf die Ursprungslogdatei (U-Log) durch den Log-Kodierer (2.2);
- Übertragen der kodierten Log-Datei (KOD-Log) von der Überwachungseinheit (2) an eine Entwicklereinheit (3);
- Einlesen der kodierten Log-Datei (KOD-Log) in einen Log-Dekodierer (3.1) durch die Entwicklereinheit (3) und Beziehen eines Versionshinweises auf ein durch den Log-Kodierer (2.2) verwendete versionierte Wörterbuch (1) oder auf die Kodierungstabelle (5) von der Überwachungseinheit (2);
- Zugriff auf eine Wörterbuchdatenbank (6.1), umfassend unterschiedlich versionierte Wörterbücher (1), durch die Entwicklereinheit (3), Bereitstellen das dem Versionshinweis entsprechenden Wörterbuchs (1) dem Log-Dekodierer (3.1) und initialisieren einer Kodierungstabelle (5) aus dem versionierten Wörterbuch (1) durch den Log-Dekodierer (3.1); und
- Erzeugen einer dekodierten Log-Datei (DEK-Log) durch Anwenden der Kodierungstabelle (5) auf die kodierte Log-Datei (KOD-Log) durch den Log-Dekodierer (3.1),
**dadurch gekennzeichnet, dass**
- die Überwachungseinheit (2) die Ursprungslogdatei (U-Log) einliest, die Kodierungstabelle (5) in Abhängigkeit der von der Ursprungslogdatei (U-Log) enthaltenen Informationen erzeugt, ein Wörterbuch (1) aus der Kodierungstabelle (5) ableitet und mit einem Versionshinweis versieht und das so versionierte Wörterbuch (1) an die Wörterbuchdatenbank (6.1) zum Speichern überträgt; und
- die Überwachungseinheit (2) die zum Erzeugen der kodierten Log-Datei (KOD-Log) verwendete Kodierungstabelle (5) aus der Ursprungslogdatei (U-Log) oder aus einem aus der Wörterbuchdatenbank (6.1) ausgelesenen versionierten Wörterbuch (1) durch den Log-Kodierer (2.2) initialisiert.

2. Verfahren nach Anspruch 1,
**dadurch gekennzeichnet, dass**
die Wörterbuchdatenbank (6.1) auf einer zentralen Recheneinrichtung (6) vorgehalten wird.

3. Verfahren nach Anspruch 1 oder 2,
**dadurch gekennzeichnet, dass**
der Log-Kodierer (2.2) beim Erzeugen der kodierten Log-Datei (KOD-Log) in Abhängigkeit des verwendeten Wörterbuchs (1) den Versionshinweis in die kodierte Log-Datei (KOD-Log) schreibt.

4. Verfahren nach einem der Ansprüche 1 bis 3,
**dadurch gekennzeichnet, dass**
die Entwicklereinheit (3) den Versionshinweis proaktiv von der Überwachungseinheit (2) abfragt oder aus der kodierten Log-Datei (KOD-Log) ausliest.

5. Verfahren nach einem der Ansprüche 1 bis 4,
**dadurch gekennzeichnet, dass**
der Log-Kodierer (2.2) die initialisierte Kodierungstabelle (5) zum Erzeugen unterschiedlicher kodierter Log-Dateien (KOD-Log) aus unterschiedlichen Ursprungslogdateien (U-Log) weiterverwendet oder beim Einlesen einer neuen Ursprungslogdatei (U-Log) die Kodierungstabelle (5) neu initialisiert.

6. Informationstechnisches System mit einer Überwachungseinheit (2) und einer Entwicklereinheit (3),
**dadurch gekennzeichnet, dass**
die Überwachungseinheit (2) und die Entwicklereinheit (3) zur Durchführung eines Verfahrens nach einem der Ansprüche 1 bis 5 eingerichtet sind.

7. Informationstechnisches System nach Anspruch 6,
**dadurch gekennzeichnet, dass**
die Überwachungseinheit (2) und die Entwicklereinheit (3) in eine gemeinsame Anlage integriert sind, insbesondere ein Fahrzeug.

8. Informationstechnisches System nach Anspruch 6,
**dadurch gekennzeichnet, dass**
die Überwachungseinheit (2) und die Entwicklereinheit (3) in separate Anlagen integriert sind oder diese ausbilden, insbesondere die Überwachungseinheit (2) in ein Fahrzeug integriert ist und die Entwicklereinheit (3) fahrzeugextern ausgeführt ist.

## Claims

1. Method for compressing and decompressing log files using adjustable dictionaries (1),
the following method steps being carried out:
- monitoring a runtime component (2.1,4) and generating an original log file (U-Log) by a monitoring unit (2), the original log file (U-Log) documenting the behavior of the runtime component (2.1,4) described during the monitoring;
- reading in the original log file (U-Log) into a log encoder (2.2) by the monitoring unit (2);
- generating an encoded log file (KOD-Log) by applying an encoding table (5) to the original log file (U-Log) by the log encoder (2.2);
- transmitting the encoded log file (KOD-Log) from the monitoring unit (2) to a developer unit (3);
- reading in the encoded log file (KOD-Log) into a log decoder (3.1) by the developer unit (3) and obtaining a version reference to a versioned dictionary (1) used by the log encoder (2.2) or to the encoding table (5) from the monitoring unit (2);
- accessing a dictionary database (6.1), comprising differently versioned dictionaries (1), by the developer unit (3), providing the dictionary (1) corresponding to the version reference to the log decoder (3.1) and initializing an encoding table (5) from the versioned dictionary (1) by the log decoder (3.1); and
- generating a decoded log file (DEK-Log) by applying the encoding table (5) to the encoded log file (KOD-Log) by the log decoder (3.1),
**characterized in that**
- the monitoring unit (2) reads in the original log file (U-Log), generates the encoding table (5) based on the information contained by the original log file (U-Log), derives a dictionary (1) from the encoding table (5) and provides it with a version reference, and transmits the thus versioned dictionary (1) to the dictionary database (6.1) for storage; and
- the monitoring unit (2) initializes the encoding table (5) used to generate the encoded log file (KOD- Log) from the original log file (U-Log) or from a versioned dictionary (1) read out from the dictionary database (6.1) by the log encoder (2.2).

2. Method according to claim 1,
**characterized in that**
the dictionary database (6.1) is kept on a central computing facility (6).

3. Method according to claim 1 or 2,
**characterized in that**
the log encoder (2.2) writes the version reference into the encoded log file (KOD-Log) when generating the encoded log file (KOD-Log) based on the dictionary (1) used.

4. Method according to any of claims 1 to 3,
**characterized in that**
the developer unit (3) proactively queries the version reference from the monitoring unit (2) or reads it out from the encoded log file (KOD-Log).

5. Method according to any of claims 1 to 4,
**characterized in that**
the log encoder (2.2) reuses the initialized encoding table (5) to generate different encoded log files (KOD-Log) from different original log files (U-Log) or reinitializes the encoding table (5) when reading in a new original log file (U-Log).

6. Information technology system comprising a monitoring unit (2) and a developer unit (3),
**characterized in that**
the monitoring unit (2) and the developer unit (3) are designed to carry out a method according to any of claims 1 to 5.

7. Information technology system according to claim 6,
**characterized in that**
the monitoring unit (2) and the developer unit (3) are integrated into a common assembly, in particular a vehicle.

8. Information technology system according to claim 6,
**characterized in that**
the monitoring unit (2) and the developer unit (3) are integrated into separate assemblies or form these assemblies, in particular the monitoring unit (2) is integrated into a vehicle and the developer unit (3) is external to the vehicle.

## Revendications

1. Procédé de compression et de décompression de fichiers journaux à l'aide de dictionnaires (1) personnalisables, dans lequel les étapes de procédé suivantes sont exécutées :
- surveillance d'un composant d'exécution (2.1, 4) et création d'un fichier journal d'origine (U-Log) par une unité de surveillance (2), dans lequel le fichier journal d'origine (U-Log) documente le comportement du composant d'exécution (2.1, 4) observé pendant la surveillance ;
- importation du fichier journal d'origine (U-Log) dans un codeur de journaux (2.2) par l'unité de surveillance (2) ;
- création d'un fichier journal codé (KOD-Log) par application d'une table de codage (5) au fichier journal d'origine (U-Log) par le codeur de journaux (2.2) ;
- transfert du fichier journal codé (KOD-Log) de l'unité de surveillance (2) vers une unité de développement (3) ;
- importation du fichier journal codé (KOD-Log) dans un décodeur de journaux (3.1) par l'unité de développement (3) et obtention, auprès de l'unité de surveillance (2), d'une indication de version relative à un dictionnaire (1) versionné utilisé par le codeur de journaux (2.2) ou à la table de codage (5) ;
- accès à une base de données de dictionnaires (6.1), comprenant des dictionnaires (1) versionnés différentes, par l'unité de développement (3), fourniture au décodeur de journaux (3.1) du dictionnaire (1) correspondant à l'indication de version et initialisation d'une table de codage (5) à partir du dictionnaire (1) versionné par le décodeur de journaux (3.1) ; et
- création d'un fichier journal décodé (DEK-Log) par application de la table de codage (5) au fichier journal codé (KOD-Log) à l'aide du décodeur de journaux (3.1),
**caractérisé en ce que**
- l'unité de surveillance (2) importe le fichier journal d'origine (U-Log), crée la table de codage (5) en fonction des informations contenues dans le fichier journal d'origine (U-Log), dérive un dictionnaire (1) à partir de la table de codage (5) et y ajoute une indication de version, puis transmet le dictionnaire (1) ainsi versionné à la base de données de dictionnaires (6.1) en vue de son enregistrement ; et
- l'unité de surveillance (2) initialise, à l'aide du codeur de journaux (2.2), la table de codage (5) utilisée pour créer le fichier journal codé (KOD-Log) à partir du fichier journal d'origine (U-Log) ou d'un dictionnaire (1) versionné extrait de la base de données de dictionnaires (6.1).

2. Procédé selon la revendication 1,
**caractérisé en ce que**
la base de données de dictionnaires (6.1) est hébergée sur un appareil de calcul central (6).

3. Procédé selon la revendication 1 ou 2,
**caractérisé en ce que**
lors de la création du fichier journal codé (KOD-Log), le codeur de journaux (2.2) inscrit l'indication de version dans le fichier journal codé (KOD-Log), en fonction du dictionnaire (1) utilisé.

4. Procédé selon l'une des revendications 1 à 3,
**caractérisé en ce que**
l'unité de développement (3) interroge de manière proactive l'unité de surveillance (2) pour obtenir l'indication de version ou l'extrait du fichier journal codé (KOD-Log).

5. Procédé selon l'une des revendications 1 à 4,
**caractérisé en ce que**
le codeur de journaux (2.2) réutilise la table de codage (5) initialisée pour créer différents fichiers journaux codés (KOD-Log) à partir de différents fichiers journaux d'origine (U-Log) ou réinitialise la table de codage (5) lors de l'importation d'un nouveau fichier journal d'origine (U-Log).

6. Système des technologies de l'information comprenant une unité de surveillance (2) et une unité de développement (3),
**caractérisé en ce que**
l'unité de surveillance (2) et l'unité de développement (3) sont configurées pour la mise en œuvre d'un procédé selon l'une des revendications 1 à 5.

7. Système des technologies de l'information selon la revendication 6,
**caractérisé en ce que**
l'unité de surveillance (2) et l'unité de développement (3) sont intégrées dans une installation commune, notamment un véhicule.

8. Système des technologies de l'information selon la revendication 6,
**caractérisé en ce que**
l'unité de surveillance (2) et l'unité de développement (3) sont intégrées dans des installations distinctes ou constituent celles-ci, notamment l'unité de surveillance (2) est intégrée dans un véhicule et l'unité de développement (3) est exécutée à l'extérieur du véhicule.
